Europäisches Patentamt

(19) European Patent Office

Office européen des brevets

(11) Veröffentlichungsnummer: **0 013 711**
**B1**

(12) EUROPÄISCHE PATENTSCHRIFT

(45) Veröffentlichungstag der Patentschrift:
15.02.84

(51) Int. Cl.³: **H 01 L 21/31, C 23 F 1/00**

(21) Anmeldenummer: **79104716.0**

(22) Anmeldetag: **27.11.79**

(54) **Verfahren zum Ätzen von Chrom.**

(30) Priorität: **26.12.78 US 972844**

(43) Veröffentlichungstag der Anmeldung:
**06.08.80 Patentblatt 80/16**

(45) Bekanntmachung des Hinweises auf die Patenterteilung:
**15.02.84 Patentblatt 84/7**

(84) Benannte Vertragsstaaten:
**DE FR GB**

(56) Entgegenhaltungen:
**EP - A - 0 002 185**
**EP - A - 0 002 798**
**US - A - 3 951 709**

**JOURNAL OF THE ELECTROCHEMICAL SOCIETY, vol. 124, no. 1, Januar 1977, Princeton, US J.F. BATTEY: "The reduction of photoresist stripping rates in an oxygen plasma by by-product inhibition and thermal mass" Seiten 147-152**
**PROCEEDINGS OF THE 6th CONFERENCE ON SOLID STATE DEVICES, Tokyo 1974 Supplement to the journal of the Japan Society of Applied Physics, vol. 44, 1975, Tokyo, JP H. ABE: "The application of gas plasma to the fabrication of MOS LSI" Seiten 287-295**

(73) Patentinhaber: *International Business Machines Corporation*, Old Orchard Road, Armonk, N.Y. 10504 (US)

(72) Erfinder: **Chiu, George Tein-Chu, 48 Brandy Lane, Wappingers Falls, New York 12590 (US)**
Erfinder: **Kitcher, James Robert, 11 Van Siclen Drive, Poughkeepsie, New York 12601 (US)**
Erfinder: **Ozols, Gunars Miervaldis, 26 West Academy Street, Wappingers Falls, New York 12590 (US)**
Erfinder: **Zingerman, Bryant Nils, 34 Duelk Avenue, Monroe, New York 10950 (US)**

(74) Vertreter: **Oechssler, Dietrich, Dr.rer.nat. Dipl.-Chem., Schönaicher Strasse 220, D-7030 Böblingen (DE)**

Verfahren zum Ätzen von Chrom

Die Erfindung betrifft ein Verfahren zum Ätzen von Chrom, welches dabei einer Glimmentladung in einer eine mehrfach chlorierte organische Verbindung und Sauerstoff oder anstelle von Sauerstoff ein Edelgas enthaltenden Gasatmosphäre ausgesetzt wird.

Das Ätzen von Materialien in einem Glasplasma, welches aus reaktiven Gasen gebildet ist, ist bekannt. Diese Verfahren können ganz allgemein in zwei Gruppen geteilt werden, welche mit den Namen «Plasmaätzen» und «reaktives Ionenätzen» bezeichnet werden. Beim Plasmaätzen liegt das Werkstück in einer Kammer und die Glimmentladung wird dadurch aufrecht erhalten, dass Hochfrequenzenergie an eine Elektrode oder Elektroden, welche sich ausserhalb der Kammer befindet bzw. befinden, gelegt wird. Bei 13,5 MHz liegen die typischen Leistungsniveaus zwischen 100 und 400 Watt und die Gasdrücke liegen zwischen 0,067 und einige μbar. In der US-A-3 951 709 ist eine solche Vorrichtung und ein solches Verfahren beschrieben. Beim reaktiven Ionenätzen liegt das Werkstück auf einer Elektrode in einer Reaktionskammer und eine Glimmentladung wird dadurch aufrechterhalten, dass Hochfrequenzenergie an die Elektrode gelegt wird. Bei einer Frequenz von 13,5 MHz liegen typische Leistungsniveaus zwischen 0,1 und 0,5 Watt/cm$^2$ und die Gasdrücke liegen zwischen 6,67 und 66,67 μbar. Beim reaktiven Ionenätzen wird gerichtet geätzt. In der US-A-3 994 793 wird ein Beispiel einer solchen Vorrichtung und eines solchen Verfahrens beschrieben.

Im US-A-3 951 709 ist ein Verfahren zum Erzeugen von Belichtungsmasken, welche bei Photoprozessen in der Halbleitertechnologie benutzt werden, offenbart, bei dem Metallschichten, wie zum Beispiel solche aus Chrom oder Gold, welche auf Glas aufgebracht sind, mittels eines Plasmaätzprozesses, bei dem Gasmischungen aus chlorhaltigen Verbindungen, wie z. B. CCl$_4$ und C$_2$HCl$_3$, mit Sauerstoff benutzt werden, geätzt werden. Im US-1-3 994 793 ist ein Verfahren zum selektiven Ätzen von Aluminium und Aluminiumlegierungen mittels reaktiven Ionenätzens offenbart, bei dem eine Halogen enthaltende Gasmischung, wie z. B. eine Mischung aus CCl$_4$ und Argon, angewandt werden.

Bei der Herstellung von Leiterzugmustern für integrierte Schaltungen beispielsweise aus Aluminium treten Probleme dadurch auf, dass das Metall an den dielektrischen Schichten schlecht haftet und dass Kontaminationen dadurch entstehen, dass der Halbleiter mit dem Leiterzugmetall eine Legierung eingeht. Deshalb werden als Barriere dienende Schichten aus Metallen, wie z. B. Chrom, Titan, Wolfram und Tantal angewandt. Diese Metallschichten müssen geätzt werden, ohne dass das Aluminium, dielektrische Schichten aus Siliciumoxid und -nitrid oder das Siliciumsubstrat beachtlich angegriffen werden. Wie z. B. in der US-A-3 615 956, in der Spalte 5, Zeilen 24 bis 26, offenbart ist, greifen Chlor enthaltende Gase Silicium stark an.

In der nicht vorveröffentlichten, jedoch nach Artikel 54 (3) EPÜ zum Stand der Technik zählenden, europäischen Patentanmeldung 78 101 788.4 [(Veröffentlichungs-Nr. EP-A-000 27 98)] ist ein Verfahren offenbart, bei dem beim reaktiven Ionenätzen der als Barriere dienenden Metallschichten Gasmischungen verwendet werden, welche 5 bis 20 Volumprozent von organischen Chlorverbindungen, wie z.B. CCl$_4$ oder C$_2$HCl$_3$, und 80 bis 95 Volumprozent Sauerstoff enthalten, wobei Aluminium und Silicium nicht wesentlich angegriffen werden. Bei dem in der genannten Patentanmeldung beschriebenen Verfahren wird SiO$_2$ messbar geätzt und bei CCl$_4$-Gehalten von mehr als ungefähr 10 Volumprozent wird Si$_3$N$_4$ geätzt.

Es ist Aufgabe der Erfindung, ein Verfahren zum Ätzen von Chrom anzugeben, bei welchem das zu ätzende Teil einer Glimmentladung ausgesetzt wird und bei welchem das Verhältnis der Ätzgeschwindigkeit von Chrom zu denjenigen der siliciumhaltigen Materialien in weiten Grenzen variiert werden kann.

Diese Aufgabe wird mit einem Verfahren der eingangs genannten Art mit dem Merkmal des kennzeichnenden Teils des Anspruchs 1 gelöst.

Der Einfluss von Wasser auf das Plasmaätzen von Silicium wurde schon untersucht. So haben Harshbarger u. a. in einem Vortrag mit dem Thema «Study of the Optical Emission from a RF Plasma During Semiconductor Etching», auf dem Kodak Microelectronics Seminar 1976 berichtet, dass die Zugabe von Wasser zu einem Plasma von CF$_4$ und O$_2$ das Ätzen von Silicium erschwert und die Bildung eines Rückstandes verursacht. Die Einflüsse des im Plasma vorhandenen Wassers werden in dem Vortrag als schädlich bezeichnet. Im Gegensatz dazu treten bei dem erfindungsgemässen Verfahren keine schädlichen Nebenwirkungen auf. Schon ein relativ kleiner Wasserdampfanteil im Gasgemisch reicht aus, um das Ätzen von Aluminium-Kupferlegierungen unabhängig von den Anteilen der übrigen Gasbestandteile zu unterdrücken. Die Ätzgeschwindigkeit von Chrom wird durch die Zugabe des Wasserdampfes nicht wesentlich beeinflusst. Die Ätzgeschwindigkeiten von siliciumhaltigen Materialien, wie Silicium, Siliciumdioxid und Siliciumnitrid, lassen sich durch Änderung des prozentualen Anteils der Gasbestandteile in so weiten Grenzen variieren, dass es mit dem erfindungsgemässen Verfahren sogar möglich ist, das Ätzen der siliciumhaltigen Materialien praktisch vollständig zu unterdrücken. Dadurch ist das erfindungsgemässe Verfahren sehr vielseitig anwendbar.

In den Sauerstoff enthaltenden Gasmischungen werden die Ätzgeschwindigkeiten durch den Wasserdampfzusatz stärker erniedrigt als in den ein Edelgas enthaltenden Mischungen.

Es ist vorteilhaft, wenn eine zwischen 2 und 5 Volumteile einer mehrfach chlorierten organischen Verbindung, zwischen 5 und 8 Volumteile von Sauerstoff oder eines Edelgases und zwischen 1 und 2 Volumteile von Wasserdampf enthaltende Gasmischung verwendet wird. Wird eine Gasmischung zum Ätzen verwendet, welche relativ wenig von der mehrfach chlorierten organischen Verbindung und relativ viel Sauerstoff oder Edelgas enthält, d. h. beispielsweise eine Gasmischung, welche ungefähr 2 Volumteile der mehrfach chlorierten organischen Verbindung, ungefähr ε Volumteile von Sauerstoff oder eines Edelgases und zwischen 1 und 2 Volumteile von Wasserdampf enthält, so werden Aluminium-Kupferlegierungen und Silicium enthaltende Materialien beim Ätzen praktisch nicht angegriffen, während die Ätzgeschwindigkeit von Chrom durch den Wasserdampfzusatz nur unwesentlich erniedrigt wird. Ist der Anteil der mehrfach chlorierten organischen Verbindung in der Gasmischung relativ hoch, so ist der Einfluss des Wasserzusatzes auf die Ätzgeschwindigkeiten der siliciumhaltigen Materialien nicht so ausgeprägt, jedoch erhält man auch dann, insbesondere bei einem Wasserdampfgehalt, welcher an der oberen Grenze liegt, – wenn man von der Ätzgeschwindigkeit des Siliciums in Edelgas enthaltenden Mischungen absieht – eine deutliche Erniedrigung der Ätzgeschwindigkeiten der siliciumhaltigen Materialien. Der Wasserdampfzusatz hat in allen Fällen den Effekt, dass Aluminium-Kupferlegierungen von den angegebenen Gasmischungen praktisch nicht geätzt werden.

Werden Ätzgruben mit senkrechten Seitenwänden angestrebt, so ist es vorteilhaft, wenn mittels reaktiven Ionenätzens geätzt wird.

Weitere vorteilhafte Ausgestaltungen des erfindungsgemässen Verfahrens ergeben sich aus den Unteransprüchen.

Die Erfidung wird anhand von durch Zeichnungen erläuterten Ausführungsbeispielen beschrieben.

Es zeigen:

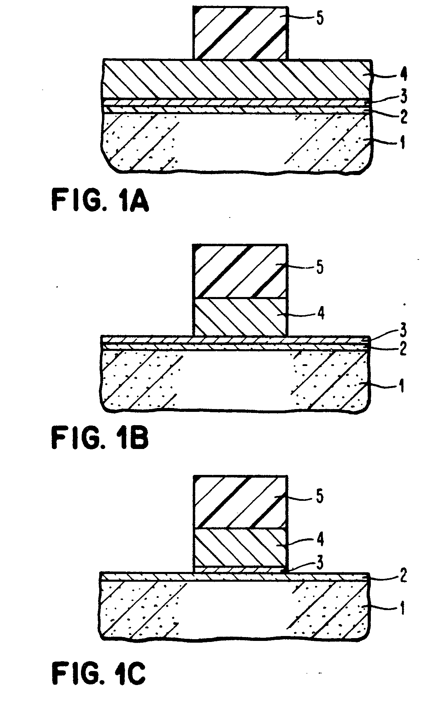

Fign. 1 A bis 1 C: Querschnittsdarstellungen eines Bauteils in drei unterschiedlichen Stadien seiner Herstellung unter Anwendung des erfindungsgemässen Verfahrens.

Das Ätzen gemäss der Erfindung wird in einer Vorrichtung zum reaktiven Ionenätzen durchgeführt. Die Vorrichtung zum reaktiven Ionenätzen ermöglicht ein gerichtetes Ätzen, so dass gerade geätzte Seitenwände und damit eine bessere Übertragung des Musters in der darüberliegenden als Maske dienenden Lackschicht als beispielsweise beim nassen Ätzen oder beim Plasmaätzen erhalten werden. Die zuletzt genannten Verfahren sind nicht gerichtet, so dass die beim Ätzen unter der Lackmaske sich bildenden und senkrecht zur geätzten Oberfläche verlaufenden Flächen (Seitenwände) ihrerseits geätzt werden.

Geeignete Vorrichtungen zum reaktiven Ionenätzen sind bekannt. Beispielsweise ist eine Vorrichtung zum reaktiven Ionenätzen in der DE-A-26 17 483 beschrieben und auch in schematischer Darstellung gezeigt (siehe Fig. 1). In dieser Vorrichtung zum reaktiven Ionenätzen liegt das zu ätzende Substrat auf einer Platte, welche ihrerseits auf einer Kathode aufliegt. Die Kathode ist mit einer Hochfrequenzleistungsquelle derart verbunden, dass sie bezüglich einer zweiten Elektrode bzw. Anode vorgespannt ist. Die Anode ist in einigem Abstand von der Kathode und parallel zu dieser angeordnet. Die Platte kann aus verschiedenen Materialien, wie z. B. Quarz, Silicium und Aluminium bestehen. Das reaktive Ionenätzen wird bei niedrigen Drucken im Bereich zwischen ungefähr 6,67 und ungefähr 66,66 µbar durchgeführt, wobei allerdings bei dem erfindungsgemässen Verfahren Drucke zwischen ungefähr 13,33 und ungefähr 40 µbar bevorzugt werden. Die Leistungsdichten liegen in einem Bereich zwischen ungefähr 0,1 und ungefähr 0,5 Watt/cm$^2$, wobei, wenn organische Lackmaskenschichten verwendet werden, die bevorzugte Leistungsdichte bei ungefähr 0,25 Watt/cm$^2$ liegt. Bei dieser Leistungsdichte wird ein übermässiger Verlust an Lackdicke vermieden. Ein unterstützendes Erhitzen der Kathodenplatte, welche dazu dient, die Temperatur des Substrats zu erhöhen, kann zur Erhöhung der Ätzgeschwindigkeiten angewandt werden. Da der Photolack dazu neigt, bei höheren Temperaturen abgebaut zu werden, muss ein Kompromiss derart gefunden werden, dass einerseits die Ätzgeschwindigkeit möglichst hoch ist, aber andererseits die Dicke der Lackschicht beim Ätzen nicht zu stark abnimmt.

Die Gasmischungen, welche zur Anwendung bei den erfindungsgemässen Verfahren geeignet sind, bestehen aus flüchtigen, mehrere Chloratome enthaltenden organischen Materialien mit ein oder zwei Kohlenstoffatomen, wie z. B. CCl$_4$ und C$_2$HCl$_3$, und Sauerstoff oder einem Edelgas und Wasser.

Die bevorzugten Zusammensetzungen aus einer mehrfach chlorierten Verbindung und Sauerstoff sind solche, welche zwischen etwa 5 und nicht mehr als ungefähr 20 Volumprozent der mehrfach chlorierten Verbindung enthalten. Wie in der europäischen Patentanmeldung 78 101 788.4 (EP-A-0002798) beschrieben ist, ist die Ätzgeschwindigkeit von Silicium und Aluminium-Kupfer beim Einsatz von so zusammengesetzten Gasmischungen sehr gering. Siliciumdioxid, Siliciumnitrid werden jedoch von so zusammengesetzten Gasmischungen noch geätzt. Der Zusatz von ungefähr 5 bis ungefähr 30 Volumprozent – der bevorzugte Bereich liegt zwischen ungefähr 10 und etwa 20 Volumprozent – von Wasserdampf zu der aus der mehrfach chlorierten Verbindung und Sauerstoff oder Edelgas bestehenden Ätzgasmischung verhindert eine beachtliche Ätzung von Siliciumdioxid und Siliciumnitrid und vermindert nicht die Ätzgeschwindigkeit von Chrom. Der Zusatz von Wasserdampf zu Gasmischungen, welche die mehrfach chlorierte Verbindung und Sauerstoff im Volumverhältnis 1:1 enthalten, vermindert aber verhindert nicht das Ätzen von Silicium, Siliciumdioxid und Siliciumnitrid, verhindert aber das Ätzen von Aluminium-Kupferlegierungen. Da die Ätzgeschwindigkeit des Chroms unabhängig davon ist, ob Gasmischungen verwendet werden, in welchen die obengenannten Bestandteile im Volumverhältnis 50:50 oder im Volumverhältnis 20:80 enthalten sind, ergibt sich kein besonderer Vorteil, wenn man die Mengen der mehrfach chlorierten Verbindung relativ zu der Sauerstoffmenge erhöht. Etwa dasselbe wurde, wie die Tabelle II weiter unten zeigt, festgestellt, wenn der Sauerstoff durch ein Edelgas, wie z.B. Helium, Argon, Neon oder Xenon ersetzt wird. Allerdings ist es offenbar so, dass bei höherer Edelgaskonzentration, d.h. bei einem Volumverhältnis von etwa 50:50, die Ätzgeschwindigkeit des Siliciums durch Zusatz von Wasserdampf nicht wesentlich beeinflusst wird.

Die folgenden Beispiele sollen die Erfindung genauer erläutern. Jedoch sei darauf hingewiesen, dass die Anwendung der Erfindung nicht auf die in den Beispielen beschriebenen Anwendungsmöglichkeiten beschränkt ist.

Beispiel I

Der Einfluss von Wasserdampf auf die Ätzgeschwindigkeiten von Silicium, Siliciumdioxid, Siliciumnitrid, Aluminium-Kupferlegierungen und Chrom wird illustriert, indem entweder Deckschichten aus den Metallen und den Siliciumverbindungen, welche auf Siliciumwafer aufgebracht worden sind, oder die Oberfläche eines einkristallinen Siliciumplättchens in einer Vorrichtung zum reaktiven Ionenätzen geätzt werden. Dabei liegen die Proben auf der Kathode. Die Leistungsdichte liegt bei 0,26 Watt/cm$^2$, der angewandte Druck liegt im Bereich zwischen 13,33 und 16 μbar und die Gasmischung enthält zwischen 2 und 5 Volumteile CCl$_4$ (Partialdruck 2,67 bis 6,67 μbar), 5 bis 8 Volumteile Argon oder Sauerstoff (Partialdruck 6,67 bis 10,67 μbar) und 0 bis 2 Volumteile Wasserdampf (Partialdruck 0 bis 2,67 μbar). Die Proben werden maskiert, indem ein ungefähr 12,7 × 12,7 mm grosses und ungefähr 0,38 mm dickes Siliciumchip auf jede Plättchenprobe gelegt wird, wodurch das reaktive Ionenätzen des dabei abgedeckten Bereichs verhindert wird. Die Höhe der Stufe, welche beim Ätzen erzeugt wird, wird gemessen. Die Ätzzeiten liegen zwischen ungefähr 2 und ungefähr 5 Minuten und die durchschnittlichen Ätzgeschwindigkeiten werden bestimmt, indem die gemessene Stufenhöhe durch die Ätzzeit geteilt wird. Die mit dem CCl$_4$-O$_2$-H$_2$-O-Mischungen erzielten Ergebnisse sind in der Tabelle 1 und die mit den CCl$_4$-Ar-H$_2$O-Mischungen erzielten Ergebnisse sind in der Tabelle II aufgelistet.

Tabelle I

| A↓   B→ | 2,67+10,67 | 2,67+10,67+1,33 | 2,67+10,67+2,67 | 6,67+6,67 | 6,67+6,67+1,33 | 6,67+6,67+2,67 | Ätzgeschwindigkeiten (nm/Min) |
|---|---|---|---|---|---|---|---|
| Si | 0 | 0 | 0 | 135 | 60 | 76 | |
| SiO$_2$ | 8,5 | 0 | 0 | 17 | 6 | 6 | |
| Si$_3$N$_4$ | 11 | 0 | 0 | 21 | 10 | 12 | |
| Cr | 24 | 24 | 20 | ≥24 | 24 | 18 | |
| Al/Cu | 0 | 0 | 0 | 11 | 0 | 0 | |

In der mit A bezeichneten Spalte sind die geätzten Materialien angegeben und in der mit B bezeichneten Zeile sind Partialdrucke in μbar der beim Ätzen verwendeten CCl$_4$-O$_2$-H$_2$O- bzw. CCl$_4$-O$_2$-Mischungen angegeben.

Tabelle II

| A↓   B→ | 2,67+10,67 | 2,67+10,67+1,33 | 2,67+10,67+2,67 | 6,67+6,67 | 6,67+6,67+1,33 | 6,67+6,67+2,67 | Ätzgeschwindigkeiten (nm/Min) |
|---|---|---|---|---|---|---|---|
| Si | 80 | <2 | <2 | 58 | 90 | 98 | |
| SiO$_2$ | 20 | <2 | <2 | 20 | 19 | 4 | |
| Si$_3$N$_4$ | 36,7 | 2 | 3,2 | 24 | 24 | 4 | |
| Cr | 20 | 18 | 20 | 16 | 18 | 12 | |
| Al/Cu | 180 | 0 | 0 | 164 | 0 | 0 | |

In der mit A bezeichneten Spalte sind die geätzten Materialien angegeben und in der mit B bezeichneten Zeile sind Partialdrucke in μbar der beim Ätzen verwendeten CCl$_4$-Ar-H$_2$O- bzw. CCl$_4$+A$_r$-Mischungen angegeben.

Man kann den in der Tabelle I aufgelisteten Ätzgeschwindigkeiten entnehmen, dass die Zugabe von 10 bis 20 Volumprozent, Wasserdampf zu einer Mischung, welche CCl$_4$ und Sauerstoff im Volumverhältnis 20:80 enthält, die Ätzgeschwindigkeit von Siliciumdioxid und Siliciumnitrid sich auf einen unmessbar, kleinen Wert erniedrigt, während die Ätzgeschwindigkeit von Chrom nicht beachtlich beeinflusst wird. Die Zugabe von 10 oder 20 Volumprozent Wasserdampf zu einer Mischung, welche CCl$_4$ und O$_2$ im Volumverhältnis 50:50 enthält, erniedrigt zwar die Geschwindigkeit, mit der Silicium enthaltende Materialien geätzt werden, jedoch verhindert diese Zugabe nicht ein messbares Ätzen dieser Materialien. Ausserdem verhindert diese Zugabe das Ätzen von Aluminium-Kupfer.

Wie aus der Tabelle II hervorgeht, brachte bei den Experimenten, bei welchen Gasmischungen verwendet wurden, welche statt Sauerstoff Argon enthielten, die Zugabe von Wasserdampf – allgemein gesprochen – dieselbe Wirkung wie bei den Experimenten mit Sauerstoff enthaltenden Gasmischungen. Ein beachtlicher Unterschied wurde insofern gefunden, als Silicium in der Abwesenheit von Wasserdampf von der Mischung, welche $CCl_4$ und Argon im Volumverhältnis von 20:80 enthielt, mit einer Ätzgeschwindigkeit von 80 nm/Min. geätzt wurde, während die Zugabe von Wasserdampf zu dieser Mischung die Ätzrate auf unter 2 nm/Min. reduzierte. Bei der Mischung, welche $CCl_4$ und Argon im Volumverhältnis 50:50 enthielt, wurde die Ätzgeschwindigkeit beim Silicium durch die Zugabe von Wasserdampf nicht so beachtlich beeinflusst, die Daten zeigen sogar einen geringen Anstieg der Ätzgeschwindigkeit durch den Wasserdampfzusatz.

Die oben angegebenen Daten zeigen, wie sich die Zugabe von Wasserdampf zu der Ätzgasmischung bei der Reduzierung des Ätzangriffs auf Silicium enthaltende Materialien und auf Aluminium-Kupferlegierungen beim Ätzen von Chrom vorteilhaft auswirkt.

Beispiel II

Eine aus Chrom und Aluminium-Kupfer aufgebaute Struktur wurde entsprechend dem erfindungsgemässen Verfahren geätzt. Die Struktur von der ausgegangen wird, ist in der Fig. 1A gezeigt und beinhaltet ein Siliciumplättchen 1, auf dessen Oberfläche übereinander eine Siliciumdioxidschicht 2 eine 0,1 μm dicke Schicht 3 aus Chrom, ein 1 μm dicke Schicht aus einer Aluminium-Kupferlegierung (96 Gew.% Aluminium und 4 Gew.% Kupfer) und schliesslich eine ein Lochmuster aufweisende, 1,5 μm dicke Photolackschicht 5 aufgebracht sind. Die Lackschicht wird gebildet, um die Struktur selektiv einem Plasmaätzprozess zu unterwerfen. Die Struktur wird auf eine Platte auf der Kathode einer Vorrichtung zum reaktiven Ionenätzen gelegt und dann wird die Aluminium-Kupferlegierung mit einer Leistung von 180 Watt bzw. einer Leistungsdichte von 0,3 Watt/cm$^2$ geätzt, wobei eine Gasmischung aus 2 Volumteilen $CCl_4$ und 8 Volumteilen Argon mit einem Gesamtdruck von 13,33 μbar angewandt wird. Die Kathodenplatte besteht aus Siliciumdioxid und die Kathode wird auf eine Temperatur im Bereich zwischen 150 und 250 Grad C erhitzt. Die Ätzzeit zum Entfernen der freiliegenden Aluminium-Kupferlegierungsschicht bis hinunter zum Chrom beträgt 10 Minuten (siehe Fig. 1B). Dann werden 2 Volumteile Wasserdampf zu der Ätzgasmischung hinzugefügt, wodurch der Gesamtdruck sich auf 16 μbar erhöht. Mit dieser Mischung wird das Chrom innerhalb von 5 Minuten bis hinunter zur Siliciumdioxidoberfläche weggeätzt, wobei weder ein messbarer Angriff auf die Aluminium-Kupferlegierungsschicht noch auf die Siliciumdioxidschicht 2 festgestellt wird. Die bei dieser Operation erzeugte Struktur ist in der Fig. 1C gezeigt. Der Photolack wird dann, ohne dass die Struktur aus der Vorrichtung herausgenommen wird, entfernt, indem 5 Minuten lang in einer aus Sauerstoff bestehenden Atmosphäre mit einem Gesamtdruck von 26,66 μbar geätzt wird.

Das erfindungsgemässe Verfahren stellt eine verbesserte Methode zum Ätzen von Chrom dar, bei der Aluminium-Kupfer, Silicium und dielektrische Schichten aus Siliciumdioxid und Siliciumnitrid nicht wesentlich angegriffen werden. Diese Methode lässt sich insbesondere bei der Herstellung der Leiterzüge für mikroelektronische Bauteile, wie z. B. integrierte Schaltungen, verwenden.

**Patentansprüche**

1. Verfahren zum Ätzen von Chrom, welches dabei einer Glimmentladung in einer eine mehrfach chlorierte organische Verbindung und Sauerstoff oder anstelle von Sauerstoff ein Edelgas enthaltenden Atmosphäre ausgesetzt wird, dadurch gekennzeichnet, dass der Atmosphäre zusätzlich Wasserdampf zugemischt wird.

2. Verfahren nach Anspruch 1, dadurch gekennzeichnet, dass eine zwischen 0,5 und 5 Volumteile einer mehrfach chlorierten organischen Verbindung, zwischen 5 und 9,5 Volumteile von Sauerstoff oder eines Edelgases und zwischen 0,5 und 2 Volumteile von Wasserdampf enthaltende Gasmischung verwendet wird, wobei sich die Volumteile der mehrfach chlorierten organischen Verbindung und von Sauerstoff bzw. des Edelgases zu 10 Volumteilen ergänzen.

3. Verfahren nach Anspruch 1 oder 2, dadurch gekennzeichnet, dass eine zwischen 2 und 5 Volumteile einer mehrfach chlorierten organischen Verbindung, zwischen 5 und 8 Volumteile von Sauerstoff oder eines Edelgases und zwischen 1 und 2 Volumteile von Wasserdampf enthaltende Gasmischung verwendet wird.

4. Verfahren nach Anspruch 3, dadurch gekennzeichnet, dass eine ungefähr 2 Volumteile der mehrfach chlorierten organischen Verbindung, ungefähr 8 Volumteile von Sauerstoff oder eines Edelgases und zwischen 1 und 2 Volumteile von Wasserdampf enthaltende Gasmischung verwendet wird.

5. Verfahren nach einem oder mehreren der Ansprüche 1 bis 4, dadurch gekennzeichnet, dass bei einem Gesamtgasdruck im Bereich zwischen 6,67 und 6,66 μbar gearbeitet wird.

6. Verfahren nach Anspruch 5, dadurch gekennzeichnet, dass bei einem Gesamtgasdruck im Bereich zwischen 13,33 und 40 μbar gearbeitet wird.

7. Verfahren nach einem oder mehreren der Ansprüche 1 bis 6, dadurch gekennzeichnet, dass eine Argon enthaltende Gasmischung verwendet wird.

8. Verfahren nach einem oder mehreren der Ansprüche 1 bis 7, dadurch gekennzeichnet, dass als mehrfach chlorierte organische Verbindung eine solche mit ein oder zwei Kohlenstoffatomen verwendet wird.

9. Verfahren nach einem oder mehreren der Ansprüche 1 bis 8, dadurch gekennzeichnet, dass mittels reaktiven Ionenätzens geätzt wird.

10. Verwendung des Verfahrens nach einem oder mehreren der Ansprüche 1 bis 9, gekennzeichnet durch die Ätzung einer Chromschicht, welche auf einem Halbleiterplättchen (1) aufgebracht und von diesem durch eine $SiO_2$-Schicht (2) getrennt ist und welche mit einer Schicht aus einer Aluminium-Kupferlegierung teilweise bedeckt ist.

**Patent Claims**

1. Method of etching chromium which is exposed in the process to a glow discharge in an atmosphere containing polychlorinated organic compounds and oxygen, or instead of oxygen to a noble gas, characterized in that water vapor is admixed to the atmosphere.

2. Method as claimed in claim 1, characterized in that a gas mixture is used containing between 0.5 and 5 percent by volume of a polychlorinated organic compound, between 5 and 9.5 percent by volume of oxygen or of a noble gas, and between 0.5 and 2 percent by volume of water vapor, the percents by volume of the polychlorinated compound and of oxygen or noble gas, respectively, supplementing each other to 10 percent by volume.

3. Method as claimed in claim 1 or 2, characterized in that a gas mixture is used containing between 2 and 5 percent by volume of a polychlorinated organic compound, between 5 and 8 percent by volume of oxygen or of a noble gas, respectively, and between 1 and 2 percent by volume of water vapor.

4. Method as claimed in claim 3, characterized in that a gas mixture is used containing approximately 2 percent by volume of the polychlorinated organic compound, approximately 8 percent by volume of oxygen or of a noble gas, respectively, and between 1 and 2 percent by volume of water vapor.

5. Method as claimed in one or several of any one of claims 1 to 4, characterized in that operation takes place at an overall gas pressure between 6.67 and 66.66 µbar.

6. Method as claimed in claim 5, characterized in that operation takes place at an overall gas pressure between 13.33 and 40 µbar.

7. Method as claimed in any one or several of claims 1 to 6, characterized in that an argon-containing gas mixture is used.

8. Method as claimed in any one or several of claims 1 to 7, characterized in that as a polychlorinated organic compound a compound with one or two carbon atoms is used.

9. Method as claimed in any one or several of claims 1 to 8, characterized in that a reactive ion etching process is used.

10. Using the method as claimed in any one or several of claims 1 to 9, characterized by the etching of a chromium layer which is applied on a semiconductor chip (1), and separated therefrom by an $SiO_2$ layer (2), and which is partly covered by a layer consisting of an aluminium-copper alloy.

**Revendications**

1. Procédé de décapage des couches de chrome exposées à une décharge luminescente dans une atmosphère contenant d'une part un composé organique polychloré et d'autre part de l'oxygène ou, au lieu d'oxygène, un gaz rare, caractérisé en ce qu'on ajoute de la vapeur d'eau dans ladite atmosphère.

2. Procédé selon la revendication 1, caractérisé en ce qu'on emploie un mélange gazeux contenant une quantité comprise entre 0,5 et 5 parties de volume d'un composé organique polychloré, une quantité comprise entre 5 et 9,5 parties de volume d'oxygène ou d'un gaz rare et une quantité comprise entre 0,5 et 2 parties de volume de vapeur d'eau où les parties de volume d'une part du composé organique polychloré et d'autre part d'oxygène ou de gaz rare se complètent pour atteindre la somme de 10 parties de volume.

3. Procédé selon la revendication 1 ou 2, caractérisé en ce qu'on emploie un mélange gazeux contenant une quantité comprise entre 2 et 5 parties de volume d'un composé organique polychloré, une quantité comprise entre 5 et 8 parties de volume d'oxygène ou d'un gaz rare et une quantité comprise entre 1 et 2 parties de volume de vapeur d'eau.

4. Procédé selon la revendication 3, caractérisé en ce qu'on emploie un mélange gazeux contenant une quantité d'environ 2 parties de volume d'un composé organique polychloré, une quantité d'environ 8 parties de volume d'oxygène ou d'un gaz rare et une quantité comprise entre 1 et 2 parties de volume de vapeur d'eau.

5. Procédé selon une ou plusieurs des revendications 1 à 4, caractérisé en ce que ledit mélange gazeux est traité sous une pression totale située dans ne fourchette allant de 6,67 à 66,66 µbar.

6. Procédé selon la revendication 5, caractérisé en ce que ledit mélange gazeux est traité sous une pression totale située dans une fourchette allant de 13,33 à 40 µbar.

7. Procédé selon une ou plusieurs des revendications 1 à 6, caractérisé en ce qu'on emploie un mélange gazeux contenant de l'argon.

8. Procédé selon une ou plusieurs des revendications 1 à 7, caractérisé en ce qu'on emploie comme composé organique polychloré un tel composé comportant un ou deux atomes de carbone.

9. Procédé selon une ou plusieurs des revendications 1 à 8, caractérisé en ce qu'on procède à un décapage aux ions réactifs.

10. Application du procédé selon une ou plusieurs des revendications 1 à 9, caractérisée par le décapage d'une couche de chrome qui est déposée sur une microplaquette semiconductrice (1) dont elle est isolée au moyen d'une couche SiO2 (2) et qui est partiellement recouverte d'une couche constituée d'un alliage aluminium-cuivre.

FIG. 1A

FIG. 1B

FIG. 1C